# EUROPÄISCHE PATENTSCHRIFT

(11) **EP 1 443 542 B1**
(45) Veröffentlichungstag und Bekanntmachung des Hinweises auf die Patenterteilung: **27.02.2008**
(21) Anmeldenummer: 04001554.7
(22) Anmeldetag: 26.01.2004
(51) Int. Cl.: H01L 21/00

(54) **Verfahren und Vorrichtung zum Kontrollieren des Randes eines scheibenförmigen Gegenstandes**
Method and device for controlling the edge of a disc shaped arcticle
Procédé et dispositif pour le contrôle du bord d'objects circulaires

(30) Priorität: 29.01.2003 DE 10303459
(43) Veröffentlichungstag der Anmeldung: 04.08.2004
(73) Patentinhaber: Infineon Technologies AG, 81669 München (DE)
(72) Erfinder: Binder, Alfred, 9023 Landskron (AT); Kroupa, Gerhard, 9500 Villach (AT); von Koblinski, Carsten, Dr., 9500 Villach (AT); Matschitsch, Martin, 9181 Feistritz i. Ros (AT)
(74) Vertreter: Kindermann, Peter

(56) Entgegenhaltungen:
- EP-A- 1 001 460
- GB-A- 2 337 111
- US-A- 5 238 354

## Beschreibung

Die Erfindung betrifft ein Verfahren und eine Vorrichtung zum Kontrollieren des Randes von scheibenförmigen Gegenständen, insbesondere im Wesentlichen kreisrunden und/oder dünnen Scheiben, wie beispielsweise Halbleiterwafern. Dünne Wafer sind Wafer, die bereits um mindestens die Hälfte ihrer ursprünglichen Dicke gedünnt worden sind. Der Rand soll vorzugsweise sowohl auf der Vorder- und auf der Rückseite kontrolliert werden, um entsprechende Aussagen für die Prozesskontrolle zu liefern.

Derzeit wird eine Randkontrolle von Wafern, insbesondere von Dünnwafern bzw. auf Trägerwafern montierten Dünnwafern ausschließlich durch eine optische Kontrolle mit Hilfe eines Mikroskops ausgeführt. Dabei wird bei einer bestimmten Vergrößerung die Waferkante optisch überprüft, allfällige Randbeschädigungen klassifiziert, beispielsweise als mikroskopischer Haarriss, als Muschelausbruch oder als ähnliche Beschädigung, und von Hand aus in eine Karte des Wafers eingetragen. Die Karte wird auch als Wafermap bezeichnet. Dieses Verfahren ist äußerst zeitintensiv und subjektiv, so dass die Klassifizierung der Randbeschädigungen bzw. Randdefekte ausschließlich auf Grundlage von subjektiven Eindrücken der die Prüfung ausführenden Person erfolgt.

Ein weiteres Problem bei der bekannten, von Hand aus durchgeführten Randkontrolle ist es, dass die Dünnwafer händisch unter das Mikroskop gebracht werden müssen. Ein automatisches Beladen des Mikroskops, mit dem die Randkontrolle durchgeführt wird, ist mit den derzeit gängigen Greifer- und Robotersystemen nicht möglich, da keine dünnwaferfähigen Greifersysteme vorliegen.

Die GB 2 337 111 A offenbart Werkstückinspektion und Handhabung. Eine Inspektionseinrichtung enthält einen Waferträger, zwei Kameras und einen Computer. Abhängig von den mit der einen Kamera aufgenommenen Bildern des sich drehenden Wafers wird das geometrische Zentrum des Wafers bestimmt. Die EP 1 001 460 A1 betrifft ein Verfahren und eine Vorrichtung zum Erfassen, Überwachen und Charakterisieren von Kantendefekten an Halbleiterwafern. Eine Inspektionseinrichtung enthält einen Waferträger und mindestens eine Kamera.

Der Erfindung liegt die Aufgabe zu Grunde, ein Verfahren und eine Vorrichtung der eingangs genannten Gattung anzugeben, mit der der Rand eines scheibenförmigen Gegenstandes, wie eines Wafers, auch wenn es sich um eine dünne Scheibe handelt, z.B. einen Dünnwafer bzw. um einen auf einem Trägerwafer montierten Dünnwafer, vollständig oder weitestgehend automatisiert ausgeführt werden kann.

Gelöst wird diese Aufgabe erfindungsgemäß mit einem Verfahren, das die Merkmale des Verfahrens des Hauptanspruches aufweist.

Bevorzugte und vorteilhafte Ausgestaltungen des erfindungsgemäßen Verfahrens sind Gegenstand der abhängigen Unteransprüche.

Insoweit die Vorrichtung betroffen ist, wird die der Erfindung zu Grunde liegende Aufgabe mit einer Vorrichtung zum Durchführen des Verfahrens mit den Merkmalen des Vorrichtungshauptanspruches gelöst.

Bevorzugte und vorteilhafte Ausgestaltungen der erfindungsgemäßen Vorrichtung sind Gegenstand der vom Vorrichtungshauptanspruch abhängigen Unteransprüche.

Das erfindungsgemäße Verfahren erlaubt eine automatisierte Kontrolle des Randes von scheibenförmigen Gegenständen, insbesondere Wafern, wobei sowohl Dünnwafer mit einer Dicke im Bereich von bspw. 50 µm bis 200 µm als auch Standardwafer mit einer Dicke bis 850 µm sowie auf Trägerwafern montierte bzw. getragene Dünnwafer in ihrem Randbereich kontrolliert werden können. Dabei wird bei einer Ausgestaltung in einem Arbeitsgang sowohl die Vorderseite als auch die Rückseite des Randes des scheibenförmigen Gegenstandes, insbesondere des Waferrandes, kontrolliert, wobei es möglich ist, Fehler und Randbeschädigungen des Gegenstandes zu unterscheiden. Solche Fehler bzw. Beschädigungen sind u.a.:
1. Muschelausbruch
2. Haarriss.

In einer Ausführungsform der Erfindung ist es möglich, Beschädigungen mit einer Größe von bis zu 50 µm zu erkennen.

In einer Ausführungsform der Erfindung wird der Rand des Gegenstandes, z.B. eines Wafers, in einer Breite von etwa 2 mm (Millimeter) auf Fehler bzw. Beschädigungen untersucht.

Wenn bei dem erfindungsgemäßen Verfahren eine Bildverarbeitung eingesetzt wird, wird durch diese die Art und Größe des Fehlers ermittelt, bspw. in einer qualitativen Messung und in einer quantitativen Messung. Die durch die Bildverarbeitung erkannten Fehler können mittels einer Klassifikation standardisiert ausgewiesen werden.

Bei dem erfindungsgemäßen Verfahren ist es in einer Ausführungsform möglich, die Art und die Lage des Fehlers bzw. der Beschädigung am Gegenstand bzw. Wafer in einer Datei zu speichern. Dies erlaubt es, eine Geschichte von Randbeschädigungen über mehrere Prozessschritte hinweg aufzuzeichnen. Hierzu kann eine spezielle Auswertesoftware vorgesehen sein, welche die erforderlichen Funktionen zur Verfügung stellt.

In der zum Ausführen des erfindungsgemäßen Verfahrens bevorzugt vorgesehenen Vorrichtung können folgende Merkmale verwirklicht sein.

Eine Spezialoptik ist vorgesehen, um sowohl die Vorder- als auch die Rückseite des Randes des Wafers mit einer einzigen Kamera gleichzeitig aufzunehmen

Mit Hilfe von Bildverarbeitungsalgorithmen können in einer Ausführungsform automatische Fehlererkennungen erfolgen und qualitative und quantitative Aussagen getroffen werden.

Mit der erfindungsgemäßen Vorrichtung ist es möglich, die Messdaten in einer Auswertesoftware zur Verfahrenskontrolle einzusetzen.

Die erfindungsgemäße Vorrichtung kann durchgängig für das Handhaben von dünnen Scheiben, wie beispielsweise dünnen Wafern ausgelegt sein. Hierzu kann ein Greifer vorgesehen sein, der nach dem Bernoulli-Prinzip in Kombination mit Unterdruck beaufschlagbaren Öffnungen arbeitet. Der Bernoulli/Vakuum-Greifer wird im folgenden kurz als B/V-Greifer bezeichnet. Außerdem können eine Zwangsübergabe vom B/V-Greifer an einen Inspektionsträger bzw. Inspektionschuck und ein dünnwafertaugliches Hordenmapping vorgesehen sein.

In einer Ausführungsform ist vorgesehen, dass der Inspektionschuck scheibenförmige Gegenstände verschiedener Größe, beispielsweise sowohl 6-Zoll- als auch 8-Zoll-Wafer, für die Randkontrolle aufnehmen und drehen kann.

Vorgesehen ist in einer Ausführungsform auch ein Lasersensor, der die Lage des Randes des Gegenstandes, z.B. den Waferrand erfasst, und die Abweichung der Mitte des Wafers von der Mitte des Trägers ermittelt und auch - sofern gewünscht - die Position des "Flat", d.h. einer Abflachung am Rand des Wafers, oder des "Notch", d.h. einer Kerbe am Rand von Wafern mit mehr als 200mm Durchmesser, ermittelt.

Die Optik zur Abbildung der Vorder- und der Rückseite des Randes des Wafers ist in einer Ausführungsform auf einem Schlitten montiert. Dies erlaubt es, durch eine Folgeregelung die Aufnahmeoptik der "exzentrisch" laufenden Waferkante nachzuführen. Vorteilhaft ist dabei, dass der Wafer nicht zentrisch auf dem Inspektionschuck liegen muss, und dass der Rand auch beim Waferflat automatisch mitkontrolliert werden kann.

Die Erfindung ist grundsätzlich bei beliebigen scheibenförmigen Gegenständen anwendbar und auch nicht auf eine bestimmte Größe des Gegenstandes bzw. Wafer beschränkt. Daher ist die in der nachfolgenden Beschreibung der Zeichnungen erfolgte Bezugnahme auf Halbleiterwafer nur als Bezugnahme auf ein bevorzugtes Beispiel zu verstehen.

Weitere Einzelheiten, Vorteile und Merkmale der Erfindung ergeben sich aus der nachstehenden Beschreibung eines bevorzugten Ausführungsbeispieles an Hand von Halbleiterwafern unter Bezugnahme auf die Zeichnungen. Darin zeigen:
- Fig. 1: schematisch eine Anlage zum Ausführen des erfindungsgemäßen Verfahrens,
- Fig. 2: schematisch und in Schrägansicht eine Inspektionsstation der Anlage von Fig. 1,
- Fig. 3: das Prinzip des optischen Sensors der Inspektionsstation, und
- Fig. 4: in einer Abfolge von sieben Bildern die Schritte beim Kontrollieren des Randes eines Wafers, bspw. eines 8-Zoll-Wafers.

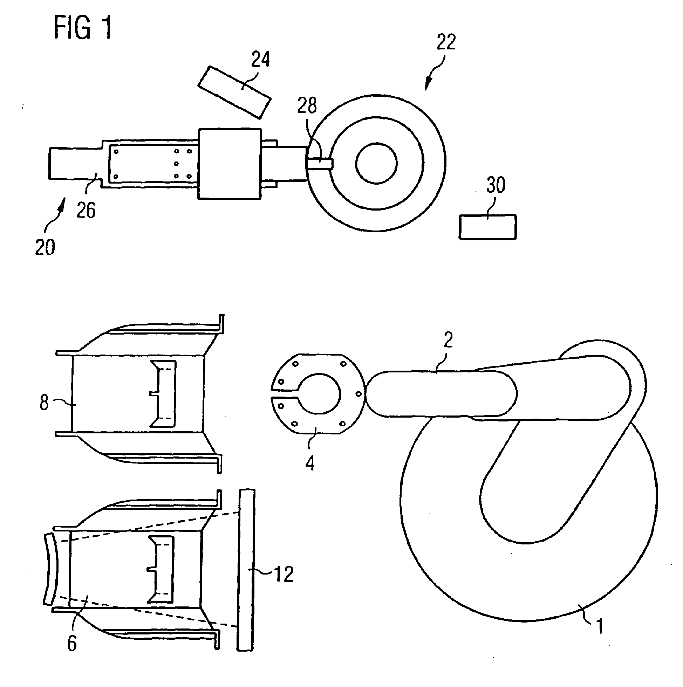

In der in Fig. 1 gezeigten Anordnung ist ein Roboter 1 vorgesehen, dessen Arm 2 mit einem für das Handhaben von Dünnwafern 10 eingerichteten Greifer 4 ausgestattet ist. Dieser Greifer 4 kann wahlweise einer Eingangs-Horde 6 und einer Ausgangs-Horde 8 zugeordnet werden. Der Eingangs-Horde 6 ist auch eine Station 12 zum "Wafermapping" zugeordnet.

In einer Inspektionsstation 20 ist ein Inspektionschuck 22 vorgesehen, dem ein Liniensensor 24 zugeordnet ist. Des weiteren ist in der Inspektionsstation 20 ein mit Hilfe eines Linearschlittens 26 linear verfahrbarer, optischer Sensorkopf 28 vorgesehen. In der Inspektionsstation 20 ist weiterhin ein Strichcodeleser 30 angeordnet.

Diese in Fig. 1 gezeigte Anordnung zeichnet sich mit Vorteil dadurch aus, dass sie durchgehend dünnwafertauglich ist. An der Eingangs-Horde 6 sowie ggf. auch an der Ausgangs-Horde 8 ist ein nicht gezeigter Wafermappingsensor installiert, welcher das Vorhandensein und die Durchbiegung der Wafer 10 in der Horde 6, 8 feststellt. weiterhin wird mit Hilfe des Wafermappingsensor festgestellt, ob ein Wafer 10 weit aus einer Horde 6, 8 vorsteht.

Der am Roboter 1 vorgesehene Dünnwafergreifer 4, der insbesondere dazu ausgelegt ist, dünne und/oder verbogene Wafer 10 zu handhaben, übernimmt den Wafertransport von der Horde 6 zur Inspektionsstation 20, von dieser zum Strichcodeleser 30 und dann zur Ausgangs-Horde 8.

Bei der Übergabe eines Wafer 10 auf den in der Inspektionsstation 20 vorgesehenen Inspektionschuck 22 mit Hilfe einer "Zwangsübergabe" übernimmt der Träger des Inspektionschuck 22 den Wafer 10 vom Greifer 4 derart, dass dieser immer gespannt, also eben bzw. flach bleibt. In diesem Zusammenhang spricht man auch von "geflatet". Dann wird aus dem Inspektionschuck 22 je nach Größe des Wafer 10 entweder der 150mm-Träger 34 oder der 200mm-Träger 36 hochgefahren und dient dem Wafer 10 bei der nachfolgenden Inspektion zur Kontrolle des Waferrandes als Halter.

Wie bereits erwähnt, kann mit Hilfe eines Liniensensors 24, z.B. eines Lasersensors, die Dezentrierung und die Lage des Flats 14 des Wafer 10 auf dem Chuck 22 in der Inspektionsstation 20 ermittelt werden, so dass bei der Inspektion der optische Sensorkopf 28 der Waferkante automatisch nachgeführt werden kann.

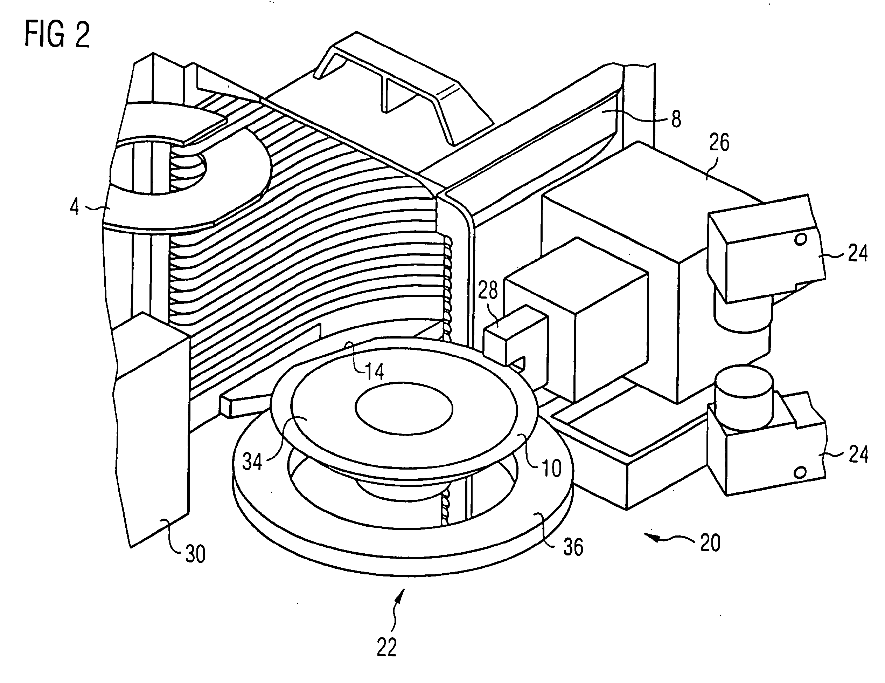

In Fig. 2 ist die Inspektionsstation 20 in Schrägansicht schematisiert dargestellt. Man erkennt die Ausgangs-Horde 8 und den Wafergreifer 4, sowie den Strichcodeleser 30, und in der eigentlichen Inspektionsstation 20 den Inspektionschuck 22 mit den Trägern 34, 36, die Wafer vom Dünnwafergreifer 4 am Roboter 1 übernehmen. Zusätzlich sind in Fig. 2 der 150mm-Träger 34 und der 200mm-Träger 36 dargestellt, die je nach der Größe des Durchmesser, z.B. 6" oder 8" (1 Zoll = 25,4 mm), des zu kontrollierenden Wafer 10 eingesetzt werden. Die träger 34 und 36 werden, wie eingangs erwähnt, alternativ hochgefahren, wobei in Fig. 2 ein 6-Zoll-Wafer 10 auf dem Chuck 22, 34 in Inspektionshöhe angeordnet ist. Auch der optische Sensorkopf 28 ist bereits im Bereich des Randes des 6-Zoll-Wafers 10 angeordnet und so ausgerichtet, dass er in einem Arbeitsgang sowohl die Vorderseite als auch die Rückseite des Randes des Wafers 10 aufnehmen kann.

Während der Kontrolle des Randes des Wafers 10 dreht sich der Träger 22 langsam mit einer Drehzahl von etwa 4 bis 6 U/min (Umdrehungen pro Minute).

Um zu gewährleisten, dass trotz der meist vorhandenen Waferexzentrizität, d.h. der Wafermittelpunkt liegt nicht im Mittelpunkt des Trägers 22, der optische Sensorkopf 28 immer im Randbereich des Wafers 10 bleibt, wird der optische Sensorkopf 28 der Waferkante nachgestellt. Dazu werden zuvor gewonnene Daten des Liniensensors 24 herangezogen. Die Daten setzen sich bspw. aus Winkeldaten und zugehörigen Waferkantenpositionsdaten zusammen.

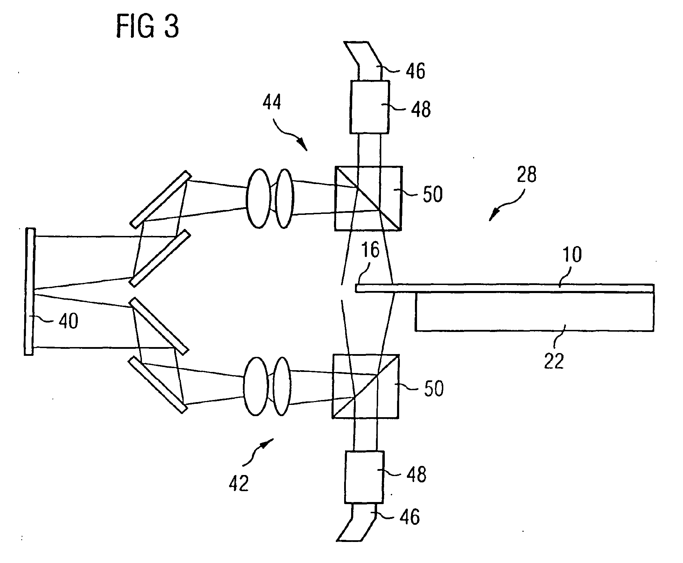

Der optische Sensorkopf 28 kann so ausgeführt werden, wie in Fig. 3 beispielhaft dargestellt. In dem in Fig. 3 dargestellten Ausführungsbeispiel werden einer Kamera 40 bzw. einem CCD-Sensor (Charged Coupled Device) über ein optisches System 42, 44 gleichzeitig Bilder der Oberseite und der Unterseite des Waferrandes 16 zugeführt. Hierzu sind zwei Beleuchtungseinrichtungen 46, bspw. Lichtwellenleiter, mit Fokussierlinsen 48 vorgesehen, die einen oberhalb und einen unterhalb des Randes 16 des Wafers 10 vorgesehenen Strahlteiler 50 mit Licht versorgen, so dass der Waferrand 16 im erforderlichen Ausmaß beleuchtet wird. Vom Waferrand 16 reflektiertes Licht wird von den Strahlteilern 50 reflektiert und gelangt über ein Linsen- und Spiegelsystem 42, 44 zu dem CCD-Sensor der Kamera 40.

In der gezeigten Ausführungsform sind immer zwei symmetrische optische Wege vorgesehen, so dass auf einem CCD-Sensor der Kamera 40 beide Seiten des Waferrandes 16 abgebildet werden.

Während sich der Wafer 10 dreht, werden die Bilder von der Kamera 40 bzw. von dem CCD-Sensor aufgenommen, der ein Linien-CCD-Sensor sein kann, und zu einem Streifen zusammengestellt. Dieser Streifen bildet die Grundlage für die weitere Bildverarbeitung.

Sobald die Kontrolle des Waferrandes abgeschlossen ist, wird vom Strichcodeleser 30 der Strichcode des Wafers 10 gelesen und dieser dann vom Dünnwafergreifer 3 in die Ausgangs-Horde 8 eingelegt. Bei einem anderen Ausführungsbeispiel wird der Strichkode vor oder während der Inspektion gelesen.

Die Bildverarbeitungsalgorithmen werden beim Ausführen der Befehle eines Programms in einer Datenverarbeitungsanlage ausgeführt und werten das vom optischen Sensor 28 aufgenommene Bild des Waferrandes 16 aus und speichern die Ergebnisse in Ordnern ab, die mit Hilfe einer Auswertesoftware bearbeitet werden können. Die Auswertesoftware ermöglicht die Ansicht der vom optischen Sensor 28 erfassten Fehler am Rand 16 des Wafer 10 sowohl in tabellarischer Form als auch grafisch in einem sogenannten "Wafer-Map". Zusätzlich kann eine Auswahl an Fehlern auch als Wafer-Map-File betrachtet werden. Bei einem anderen Ausführungsbeispiel wird eine Schaltung ohne Prozessor zur Durchführung der Bildverarbeitung genutzt.

Zur Verfahrenskontrolle ermöglicht es die Auswertesoftware, mehrere nach aufeinanderfolgenden Behandlungsschritten ausgeführte Kontrollen des Randes des Wafers bzw. deren Ergebnisse gleichsam übereinander zu legen und so einen Wafer 10 über mehrere Behandlungsstufen hinweg zu kontrollieren. Alternativ erlaubt es die Auswertesoftware, mehrere Chargen unterschiedlicher Wafer 10 miteinander zu vergleichen. So kann ermittelt werden, ob und wenn ja welche Verfahrensstufen fehleranfällig sind, d.h. zu Fehlern im Waferrand Anlass geben, und ein Qualitätsrisiko in der Fertigungslinie darstellen.

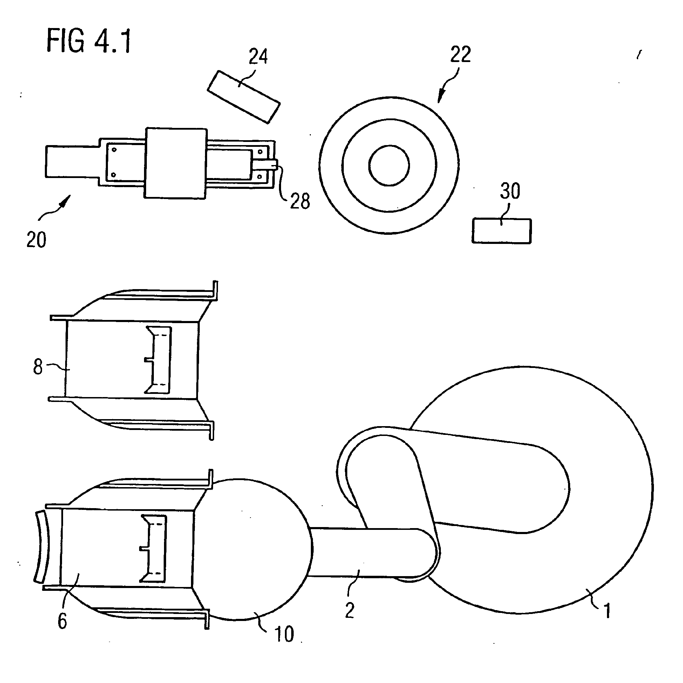

Nachstehend wird ein Beispiel eines Ablaufes der Kontrolle eines Randes 16 eines Wafer 10 anhand der Fig. 4.1 bis 4.7 beschrieben.

In 4.1 ist die Stellung gezeigt, in der ein Wafer 10 aus der Eingangs-Horde 6 entnommen wird.

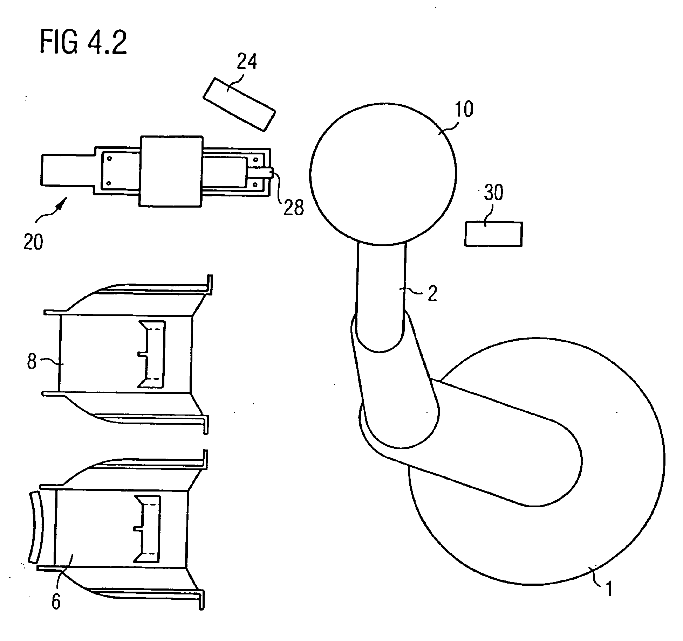

Dieser der Eingangs-Horde 6 entnommene Wafer 10 wird dann, wie in Fig. 4.2 dargestellt, auf den Inspektionschuck 22 abgelegt. Hierzu fährt zunächst der entsprechende Subchuck des Inspektionschuck 22 aus und übernimmt den Wafer 10 mit Vakuum-Übergabe direkt vom Dünnwafergreifer 4. Der Dünnwafergreifer 4 gibt den Wafer 10 durch Aufheben seines Vakuums frei und fährt dann nach unten und hinten weg. Zur vollflächigen Unterstützung des Wafers 10 fährt der passende Chuck 34, 36, z.B. der 200mm-Chuck 36 aus, und spannt den Wafer 10 ebenfalls mit Vakuum. Dabei ragt der Waferrand immer noch allseitig über den Chuck 34 bzw. 36 hinaus.

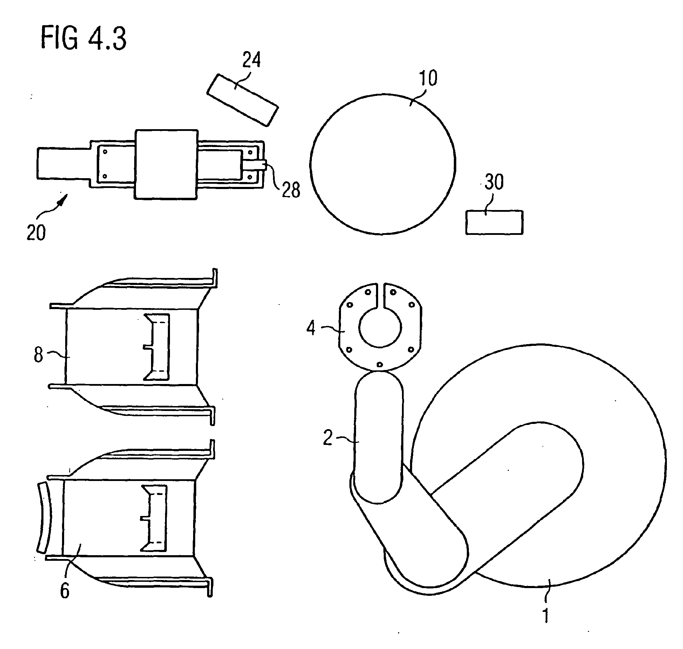

In Fig. 4.3 ist gezeigt, dass der Roboter 1 mit dem Dünnwafergreifer 4 zurückgefahren ist und der Wafer 10 auf dem Inspektionschuck 22 gespannt, d.h. ordnungsgemäß angeordnet ist.

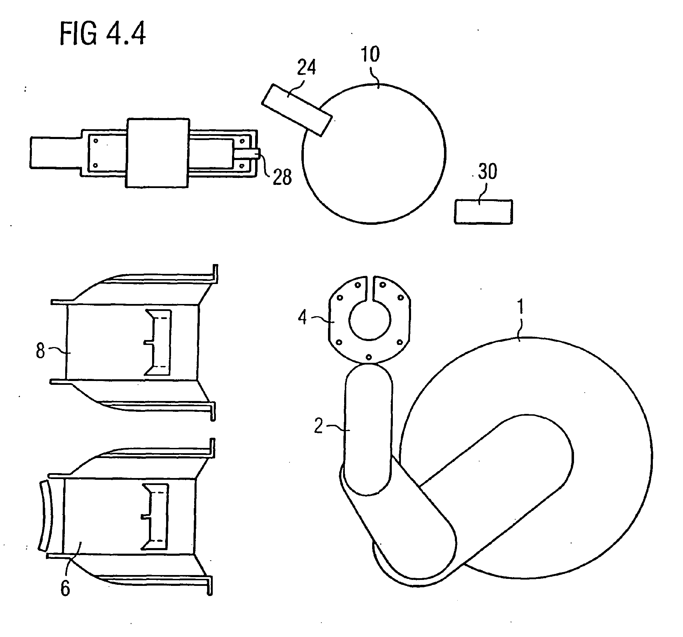

Wie aus Fig. 4.4 ersichtlich, ist der Liniensensor 24 vorgefahren worden, um den Waferrand 16 zu scannen, wobei sich der Wafer 10 einmal um 360° dreht. Dadurch wird die Lage der Waferkante 16 gemessen und daraus die Exzentrizität des Wafers 10 berechnet. Wenn 6-Zoll-Wafer 10 in ihrem Randbereich 16 kontrolliert werden, wird vom Liniensensor 24 auch der Flat 14 erfasst, d.h. die abgeflachte Stelle am Umfangsrand des Wafers 10. Die Positionsdaten für die Waferkante 16, die vom Liniensensor 24 erfasst worden sind, werden in der Inspektionsstation 20 gespeichert.

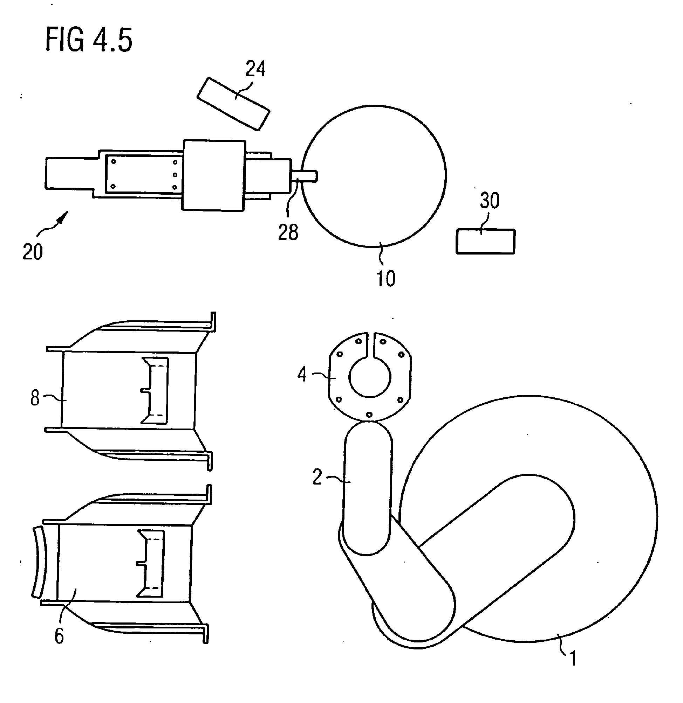

In Fig. 4.5 ist die Situation dargestellt, bei welcher der optische Sensor 28 mit Hilfe seines Linearantriebes 26 in die dem Rand 16 des Wafers 10 zugeordnete Lage vorgefahren ist. Aufgrund der oben beschriebenen Konstruktion des optischen Sensors 28 werden sowohl die Vorder- als auch die Rückseite des Wafers 10, d.h. die obere Seite und die untere Seite, im Randbereich 16 untersucht. Der Randbereich 16 hat bspw. eine Breite von etwa 2 mm (Millimeter). So fern der Wafer 10 - was meist der Fall sein wird - nicht zentrisch auf dem Träger 22 liegt, werden die zuvor gespeicherten und vom Liniensensor 24 erfassten Positionsdaten dazu herangezogen, den optischen Sensor 28 mit Hilfe seines Linearschlittens 26 so radial zum Wafer 16 zu verstellen, dass er dem Rand 16 des Wafers 10 stets nachgeführt wird. Wenn ein 6-Zoll-Wafer 10 mit Flat 14 kontrolliert werden soll, kann so dafür gesorgt werden, dass der Rand 16 auch im Bereich des Flat 14 durch entsprechendes Bewegen des optischen Sensors 28 beim Drehen des Wafers 10 kontrolliert wird.

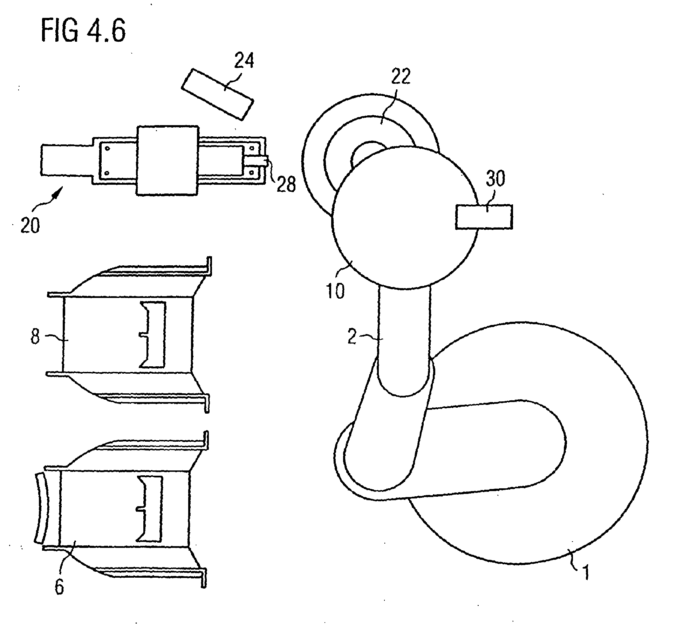

Fig. 4.6 zeigt, wie der Wafer, nachdem sein Rand kontrolliert worden ist, positionskorrigiert vom Subchuck 22 auf den Dünnwafergreifer 4 übergeben wird. Auf diese Weise wird eine zunächst vorhandene Exzentrizität dadurch ausgeglichen, dass der Dünnwafergreifer 4 den Wafer 10 so erfasst, dass der Mittelpunkt des Wafers 10 genau die gewünschte Lage auf dem Dünnwafergreifer 4 einnimmt, wobei dann meist der Mittelpunkt des Wafer 4 mit dem Mittelpunkt des Dünnwafergreifers 4 zusammenfällt. Nachdem der Wafer 10 vom Dünnwafergreifer 4 übernommen worden ist, wird der am Wafer 10 angeordnete Strichcode mit Hilfe des Strichcodelesers 30 gelesen, wie dies in Fig. 4.6 ebenfalls gezeigt ist.

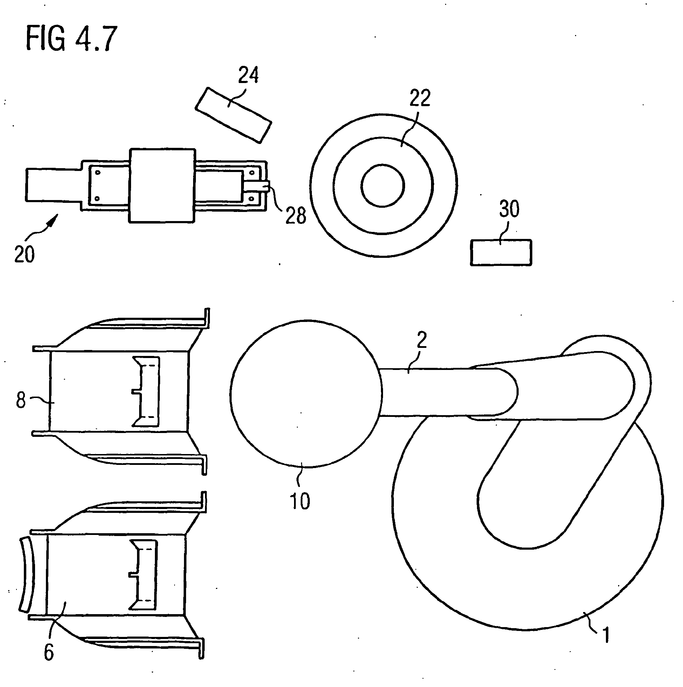

Nachdem dies ausgeführt worden ist, wird, wie in Fig. 4.7 dargestellt, der Wafer 10 vom Dünnwafergreifer 4 in die Ausgangs-Horde 8 abgelegt.

Es ist noch darauf hinzuweisen, dass bei der beschriebenen Verfahrensweise und mit Hilfe der beschriebenen Vorrichtung nicht nur der Waferflat 14 bei 6-Zoll-Wafern 10 automatisch mitgemessen werden kann; sondern dass nach einer 360°-Umdrehung auf dem Inspektionschuck 22 der Wafer so gedreht werden kann, dass der Waferflat 14 in die für den Rücktransport und die Ablage in der Ausgangs-Horde 8 gewünschte Position gebracht wird und der Dünnwafergreifer 4 den Wafer 10 positionskorrigiert vom Inspektionschuck 22 (Subchuck) übernimmt und diesen mit der gewünschten Ausrichtung in die Ausgangs-Horde 8 ablegt.

Zusammenfassend kann ein bevorzugtes Ausführungsbeispiel des erfindungsgemäßen Verfahrens und der Vorrichtung zum Kontrollieren des Randes eines Halbleiterwafers wie folgt beschrieben werden:

Beim Kontrollieren des Randbereiches eines Wafer auf Fehler, wie Haarrisse und/oder Muschelausbrüche, wird der Randbereich des Wafer gleichzeitig an beiden Seiten, d.h. oben und unten, durch einen mit einer Kamera ausgestatteten optischen Sensor abgebildet, während sich der Wafer um eine zu seiner Fläche normale Achse dreht. Die so gewonnenen Bilder werden gespeichert. Um bei exzentrisch auf einem sich drehenden Träger gehaltenem Wafer den optischen Sensor dem Randbereich beim Aufnehmen des Randbereiches nachführen zu können, wird der Verlauf des Randbereiches vorher bestimmt, indem der auf dem Träger gehaltene Wafer im Bereich eines Liniensensors gedreht wird. Entsprechend dem so ermittelten Verlauf des Randbereiches des Wafer wird der optische Sensor radial zu dem den Wafer drehenden Träger bewegt, so dass er stets - und auch im Bereich eines allenfalls vorhandenen Flat am Waferrand - zum Rand des Wafer richtig ausgerichtet bleibt.

## Patentansprüche

1. Verfahren zum automatischen Kontrollieren des Randes (16) eines scheibenförmigen Gegenstandes (10), insbesondere eines Wafers (10), wobei Bilder der Oberseite und/oder der Unterseite im Randbereich des Gegenstandes aufgenommen werden,
**dadurch gekennzeichnet , dass** während des Aufnehmens der Bilder der Ober- und/oder der Unterseite des Randes (16) des Gegenstandes (10) Relativbewegungen des Randes (16) des Gegenstandes (10) relativ zum Mittelpunkt der Drehung kompensiert werden.

2. Verfahren nach Anspruch 1, **dadurch gekennzeichnet, dass** der Gegenstand (10) während des Erzeugens der Bilder seines Randes (16) kontinuierlich gedreht wird.

3. Verfahren nach Anspruch 1 oder 2, **dadurch gekennzeichnet,**
**dass** die Bilder der Unterseite und der Oberseite gleichzeitig aufgenommen werden,
und/oder dass ein mittlerer Bereich der Oberseite und der Unterseite nicht aufgenommen wird.

4. Verfahren nach einem der Ansprüche 1 bis 3, **dadurch gekennzeichnet , dass** ein etwa 2 mm breiter Randbereich des Gegenstandes (10) kontrolliert wird.

5. Verfahren nach einem der Ansprüche 1 bis 4, **dadurch gekennzeichnet , dass** ermittelte Fehlstellen klassifiziert werden, insbesondere in Muschelausbruch und Haarriss.

6. Verfahren nach einem der Ansprüche 1 bis 5, **dadurch gekennzeichnet , dass** Art und Lage der Beschädigung des Gegenstandes (10) in einer Datei gespeichert werden.

7. Verfahren nach einem der Ansprüche 1 bis 6, **dadurch gekennzeichnet , dass** vor oder nach oder beim Aufnehmen der Bilder des Randes (16) des Gegenstandes (10) der Verlauf des Randes (16) des Gegenstandes (10) relativ zu dem Mittelpunkt erfasst wird, um den der Gegenstand (10) beim Aufnehmen gedreht wird.

8. Verfahren nach einem der Ansprüche 1 bis 7, **dadurch gekennzeichnet , dass** vor dem Aufnehmen der Bilder des Randes (16) des Gegenstandes (10) die Lage einer Markierung (14) am Rand (16) des Gegenstandes (10) erfasst wird, wie einer abgeflachten Stelle oder einer Kerbe am Rand eines Wafers (10).

9. Verfahren nach einem der Ansprüche 1 bis 8, **dadurch gekennzeichnet , dass** ein Gegenstand (10) nach dem Kontrollieren des Randes (16) positionskorrigiert abgelegt wird, insbesondere auf einem Greifer (4), der ihn zu einer Ausgangs-Horde (8) bewegt.

10. Vorrichtung zum Kontrollieren des Randes (16) eines scheibenförmigen Gegenstandes (10) zum Durchführen des Verfahrens nach einem der Ansprüche 1 bis 9, mit einem Greifer (4), der an einem Bewegungsroboter (1) vorgesehen ist, mit einer Inspektionsstation (22) mit einem Sensor (28) zum Erzeugen von Bildern des Randes (16) des Gegenstandes (10) und mit einem Träger (22) zum Drehen des Gegenstandes (10) relativ zum Sensor (28),
**dadurch gekennzeichnet , dass** in der Inspektionsstation (20) ein Liniensensor (24) zum Erfassen des Verlaufes des Randes (16) des Gegenstandes (10) beim Drehen desselben auf dem Träger (22) vorgesehen ist,
dass der optische Sensor (28) auf einem Linearschlitten (26) montiert ist, über den er radial zum Träger (22) verstellbar ist, und
**dass** der Antrieb für den Linearschlitten (26) unter Ausnutzung der vom Liniensensor (24) erfassten Daten über den Verlauf des Randes (16) des Gegenstandes (10) gesteuert ist.

11. Vorrichtung nach Anspruch 10, **dadurch gekennzeichnet, dass** der Träger (22) ein Inspektionschuck (22) ist.

12. Vorrichtung nach Anspruch 10 oder 11, **dadurch gekennzeichnet, dass** in der Inspektionsstation (20) ein Strichcodeleser (30) zum Lesen des Strichcodes auf dem Gegenstand (10) vorgesehen ist.

13. Vorrichtung nach einem der Ansprüche 10 bis 12, **dadurch gekennzeichnet , dass** der Sensor (28) ein optischer Sensor (28) ist.

14. Vorrichtung nach Anspruch 13, **dadurch gekennzeichnet, dass** der Sensor (28) zwei symmetrische Wege (42, 44) enthält.

15. Vorrichtung nach einem der Ansprüche 10 bis 14, **dadurch gekennzeichnet ,**
**dass** ein CCD-Sensor (40), insbesondere ein Linien-CCD-Sensor, vorgesehen ist, auf dem vorzugsweise beide Seiten des Randes (16) des Gegenstandes (10) gleichzeitig abgebildet werden.

16. Vorrichtung nach einem der Ansprüche 10 bis 15, **dadurch gekennzeichnet , dass** der Sensor (28) zwei Strahlungsquellen (46) enthält, insbesondere zwei Lichtquellen (46), die Strahlung auf den Rand (16) des Gegenstandes (10) von oben und von unten her durch Strahlteiler (50) abgeben,
und/oder dass vom Rand (16) des Gegenstandes (10) reflektierte Strahlung durch die Strahlteiler (50) vorzugsweise über ein Linsen-/Spiegel-System (42, 44) dem Sensor (40) zugeleitet wird.

17. Vorrichtung nach einem der Ansprüche 10 bis 16, **dadurchgekennzeichnet** , **dass** der Greifer (4) am Handhabungsroboter (1) als Dünnwafergreifer ausgebildet ist.

18. Vorrichtung nach einem der Ansprüche 10 bis 17, **dadurch gekennzeichnet , dass** der in der Inspektionsstation (20) vorgesehene Träger (22) einen zentral angeordneten Hilfsträger und zwei wahlweise einsetzbare Zusatzträger (34, 36) aufweist.

## Claims

1. Method for automatically inspecting the edge (16) of a disc-like article (10), particularly a wafer (10), where pictures of the top and/or the underside are taken in the edge region of the article, **characterized in that** while the pictures of the top and/or the underside of the edge (16) of the article (10) are being taken, relative movements of the edge (16) of the article (10) relative to the midpoint of rotation are compensated for.

2. Method according to Claim 1, **characterized in that** the article (10) is continually rotated while the pictures of its edge (16) are being produced.

3. Method according to Claim 1 or 2, **characterized in that** the pictures of the underside and the top are taken at the same time,
and/or **in that** a central region of the top and the underside is not taken.

4. Method according to one of Claims 1 to 3, **characterized in that** an approximately 2-mm-wide edge region of the article (10) is inspected.

5. Method according to one of Claims 1 to 4, **characterized in that** ascertained defects are classified, particularly into chipping and hairline cracking.

6. Method according to one of Claims 1 to 5, **characterized in that** the type and position of the damage to the article (10) are stored in a file.

7. Method according to one of Claims 1 to 6, **characterized in that** before or after or while the pictures of the edge (16) of the article (10) are taken, the profile of the edge (16) of the article (10) relative to the midpoint about which the article (10) is rotated while the pictures are being taken is detected.

8. Method according to one of Claims 1 to 7, **characterized in that** before the pictures of the edge (16) of the article (10) are taken, the position of a marker (14) at the edge (16) of the article (10) is detected, such as a flattened location or a notch at the edge of a wafer (10).

9. Method according to one of Claims 1 to 8, **characterized in that** following inspection of the edge (16) an article (10) is put down in the correct position, particularly on a gripper (4) which moves it to an output rack (8).

10. Apparatus for inspecting the edge (16) of a disc-like article (10) for carrying out the method according to one of Claims 1 to 9, having a gripper (4) which is provided on a movement robot (1), having an inspection station (22) having a sensor (28) for producing pictures of the edge (16) of the article (10) and having a support (22) for rotating the article (10) relative to the sensor (28),
**characterized in that** the inspection station (20) contains a line sensor (24) for detecting the profile of the edge (16) of the article (10) when it rotates on the support (22),
**in that** the optical sensor (28) is mounted on a linear carriage (26) which can be used to adjust it radially relative to the support (22), and
**in that** the drive for the linear carriage (26) is controlled by utilizing the data captured by the line sensor (24) about the profile of the edge (16) of the article (10).

11. Apparatus according to Claim 10, **characterized in that** the support (22) is an inspection chuck (22).

12. Apparatus according to Claim 10 or 11, **characterized in that** the inspection station (20) contains a barcode reader (30) for reading the barcode on the article (10).

13. Apparatus according to one of Claims 10 to 12, **characterized in that** the sensor (28) is an optical sensor (28).

14. Apparatus according to Claim 13, **characterized in that** the sensor (28) contains two symmetrical paths (42, 44).

15. Apparatus according to one of Claims 10 to 14, **characterized in that** a CCD sensor (40), particularly a line CCD sensor, is provided, on which preferably both sides of the edge (16) of the article (10) are mapped at the same time.

16. Apparatus according to one of Claims 10 to 15, **characterized in that** the sensor (28) contains two radiation sources (46), particularly two light sources (46), which emit radiation onto the edge (16) of the article (10) from above and from below through beam splitters (50),
and/or **in that** radiation reflected from the edge (16) of the article (10) is supplied to the sensor (40) by the beam splitters (50) preferably via a lens/mirror system (42, 44).

17. Apparatus according to one of Claims 10 to 16, **characterized in that** the gripper (4) on the handling robot (1) is in the form of a thin-wafer gripper.

18. Apparatus according to one of Claims 10 to 17, **characterized in that** the support (22) provided in the inspection station (20) has a centrally arranged auxiliary support and two selectively usable supplementary supports (34, 36).

## Revendications

1. Procédé de contrôle automatique du bord (16) d'un objet (10) en forme de disque, notamment d'une tranche (10) en enregistrant des images de la face supérieure et/ou de la face inférieure dans la partie de bord de l'objet, **caractérisé en ce que**, pendant que l'on enregistre les images de la face supérieure et/ou de la face inférieure du bord (16) de l'objet (10), on compense des mouvements relatifs du bord (16) de l'objet (10) par rapport au centre de rotation.

2. Procédé suivant la revendication 1, **caractérisé en ce que** l'on fait tourner continuellement l'objet (10) pendant la production des images de son bord (16).

3. Procédé suivant la revendication 1 ou 2, **caractérisé en ce que** l'on enregistre simultanément les images de la face inférieure et de la face supérieure,
et/ou **en ce que** l'on n'enregistre pas une partie au milieu de la face supérieure et de la face inférieure.

4. Procédé suivant l'une des revendications 1 à 3, **caractérisé en ce que** l'on contrôle une partie de bord de l'objet (10) d'une largeur d'environ 2 mm.

5. Procédé suivant l'une des revendications 1 à 4, **caractérisé en ce que** l'on classe des points défectueux déterminés, notamment en éruption conchoïdale et en fissure filiforme.

6. Procédé suivant l'une des revendications 1 à 5, **caractérisé en ce que** l'on mémorise dans un fichier le type et la position de l'endommagement de l'objet (10).

7. Procédé suivant l'une des revendications 1 à 6, **caractérisé en ce qu'**avant ou après ou lors de l'enregistrement des images du bord (16) de l'objet (10), on relève le tracé du bord (16) de l'objet (10) par rapport au centre pour faire tourner l'objet (10) lors de l'enregistrement.

8. Procédé suivant l'une des revendications 1 à 7, **caractérisé en ce qu'**avant l'enregistrement des images du bord (16) de l'objet (10), on relève la position d'un repère (14) sur le bord de l'objet (10) comme un méplat ou une entaille sur le bord d'une tranche (10).

9. Procédé suivant l'une des revendications 1 à 8, **caractérisé en ce que** l'on met, d'une manière corrigée en position, un objet (10), après le contrôle du bord (16), notamment sur un dispositif (4) de préhension, qui le déplace vers un plateau (8) de sortie.

10. Dispositif de contrôle du bord (16) d'un objet (10) en forme de disque pour effectuer le procédé suivant l'une des revendications 1 à 9, comprenant un dispositif (4) de préhension, qui est prévu sur un robot (1) de déplacement, un poste (22) d'inspection ayant un capteur (28) pour produire des images du bord (16) de l'objet (10) et un support (22) pour faire tourner l'objet (10) par rapport au capteur (28),
**caractérisé en ce qu'**il est prévu dans le poste (20) d'inspection un capteur (24) de ligne pour relever le tracé du bord (16) de l'objet (10) lors de sa rotation sur le support (22),
**en ce que** le capteur (28) optique est monté sur un chariot (26) linéaire sur lequel il peut être déplacé radialement par rapport au support (22), et
**en ce que** l'entraînement du chariot (26) linéaire est commandé en utilisant les données sur le tracé du bord (16) de l'objet (10) relevées par le capteur (24) de ligne.

11. Dispositif suivant la revendication 10, **caractérisé en ce que** le support (22) est un mandrin (22) d'inspection.

12. Dispositif suivant la revendication 10 ou 11, **caractérisé en ce qu'**il est prévu dans le poste (20) d'inspection un lecteur (30) de code barre pour lire le code barre sur l'objet (10).

13. Dispositif suivant l'une des revendications 10 à 12, **caractérisé en ce que** le capteur (28) est un capteur (28) optique.

14. Dispositif suivant la revendication 13, **caractérisé en ce que** le capteur (28) comporte deux voies (42, 44) symétrique.

15. Dispositif suivant l'une des revendications 10 à 14, **caractérisé en ce qu'**il est prévu un capteur (40) CCD notamment un capteur CCD de ligne, sur lequel, de préférence, les deux faces du bord (16) de l'objet (10) sont reproduites simultanément.

16. Dispositif suivant l'une des revendications 10 à 15, **caractérisé en ce que** le capteur (28) comporte deux sources (46) de rayonnement, notamment deux sources (46) lumineuses, qui émettent par un diviseur (50) de faisceau du rayonnement sur le bord (16) de l'objet (10) à partir du haut et à partir du bas,
et/ou **en ce que** du rayonnement réfléchi par le bord (16) de l'objet (10) est envoyé au capteur (50) par le diviseur (50) de faisceau en passant, de préférence, par un système (42, 44) à lentille/miroir.

17. Dispositif suivant l'une des revendications 10 à 16, **caractérisé en ce que** le dispositif (4) de préhension est constitué en dispositif de préhension de tranche mince sur le robot (1) de manipulation.

18. Dispositif suivant l'une des revendications 10 à 17, **caractérisé en ce que** le support (12) prévu dans le poste (20) d'inspection a un support auxiliaire disposé de façon centrale et deux supports (34, 36) supplémentaires pouvant être utilisés à volonté.
